# EUROPÄISCHE PATENTANMELDUNG

(11) **EP 4 376 108 A1**
(43) Veröffentlichungstag der Anmeldung: **29.05.2024**
(21) Anmeldenummer: 23000158.8
(22) Anmeldetag: 14.11.2023
(51) Int. Cl.: H01L 33/62, H01L 23/495

(54) **DIODENANORDNUNG**

(30) Priorität: 23.11.2022 DE 102022004377
(71) Anmelder: AZUR SPACE Solar Power GmbH, 74072 Heilbronn (DE)
(72) Erfinder: Zrinscak, Ivica, 74074 Heilbronn (DE)
(74) Vertreter: Koch Müller Patentanwaltsgesellschaft mbH

(57) **Zusammenfassung**

Diodenanordnung (DA) aufweisend, eine Halbleiterdiode (D1) mit einem p / n Übergang, wobei die Halbleiterdiode eine Oberseite (OS) und eine Unterseite (US) aufweist, und an der Oberseite (OS) ein erster elektrischer Kontakt (K1) und an der Unterseite ein zweiter elektrischer Kontakt (K2) ausgebildet ist, die Halbleiterdiode ungehäust als flächiges Die ausgebildet ist und eine plane Oberseite und eine plane Unterseite aufweist und die metallisierte Oberseite den ersten Kontakt (K1) und die metallisierte Unterseite den zweiten Kontakt (K2) der Halbleiterdiode ausbildet,

ein erster flacher metallischer Verbinder (VB1) mit einer ersten Kontaktfläche (KF1) und einer von der ersten durch ein Verbindungsstück (VBS) beabstandeten zweiten Kontaktfläche (KF2) und

ein zweiter flacher metallischer Verbinder (VB2) mit einer ersten Kontaktfläche (KF1) und einer von der ersten durch ein Verbindungsstück (VBS) beabstandeten zweiten Kontaktfläche (KF2), und

die metallisierte Oberseite (OS) stoffschlüssig mit einer der beiden Kontaktflächen (KF1, KF2) des ersten metallischen Verbinders (VB1) verbunden ist, und die metallisierte Unterseite (US) stoffschlüssig mit einer der beiden Kontaktflächen (KF1, KF2) des zweiten metallischen Verbinders verbunden ist.

## Beschreibung

Diodenanordnungen sowohl in integrierter als auch in einer diskreten Ausführungsformen werden seit vielen Jahrzehnten in großer Zahl zum Schutz von Schaltungen und / oder zum Schutz von Motoren und Ansteuerungen und / oder zum Schutz von Batterien eingesetzt. Insbesondere werden derartige Dioden als sogenannter Verpolungsschutz eingesetzt.

Vor diesem Hintergrund besteht die Aufgabe der Erfindung darin, eine Vorrichtung anzugeben, die den Stand der Technik weiterbildet.

Die Aufgabe wird durch eine Diodenanordnung mit den Merkmalen des Patentanspruchs 1 gelöst. Vorteilhafte Ausgestaltungen der Erfindung sind Gegenstand von Unteransprüchen.

Nach dem Gegenstand der Vorrichtung wird eine Diodenanordnung als ungehäustes Fertigprodukt bereitgestellt mit einer Halbleiterdiode mit genau einem p / n Übergang.

Die Halbleiterdiode weist eine p-dotierte Oberseite und eine n-dotierte Unterseite oder eine n-dotierte Oberseite und eine p-dotierte Unterseite auf.

An der Oberseite ist ein erster elektrischer Kontakt und an der Unterseite ein zweiter elektrischer Kontakt ausgebildet.

Die ungehäuste Halbleiterdiode ist als diskretes Bauelement und als flächiges Die ausgebildet.

Des Weiteren weist die Halbleiterdiode eine plane Oberseite und eine plane Unterseite auf, wobei die Fläche der Oberseite und die Fläche der Unterseite vollständig oder wenigstens zu mehr als 80% oder zu mehr als 90% metallisiert sind.

In einer Ausführungsform ist die Fläche an der Unterseite und / oder an der Oberseite nicht zu 100% metallisiert. Hierbei ist ein umlaufender Bereich an dem Rand bzw. an der Kante nicht metallisiert, um Kurzschlüsse zwischen Oberfläche und Seitenfläche zu vermeiden. Insbesondere wird bei der Herstellung die Halbleiterscheibe eine Vereinzelung der Vielzahl von Dioden zumeist mittels eines, Sägeprozesses durchgeführt. Mittels des umlaufenden metallfreien Bereichs an der Kante wird ein Verschmieren von Metall entlang der Seitenfläche verhindert.

Die überwiegende metallisierte Oberseite bildet den ersten Kontakt und die metallisierte Unterseite den zweiten Kontakt der Halbleiterdiode aus.

Hierbei ist der erste Kontakt als Kathode und der zweite Kontakt als Anode oder der erste Kontakt als Anode und der zweite Kontakt als Kathode ausgebildet.

Des Weiteren ist ein erster flacher metallischer Verbinder mit einer ersten Kontaktfläche und einer von der ersten durch ein Verbindungsstück beabstandeten zweiten Kontaktfläche vorgesehen.

Ferner ist ein zweiter flacher metallischer Verbinder mit einer ersten Kontaktfläche und einer von der ersten durch ein Verbindungsstück beabstandeten zweiten Kontaktfläche vorgesehen.

Das Verbindungsstück nicht oder nicht mehr als 1,5 mm oder als 2,5 mm aus einer von der ersten Kontaktfläche und / oder von der zweiten Kontaktfläche bestimmten Ebene hinaussteht.

Es sei angemerkt, dass in der Ausführungsform bei der das Verbindungsstück nicht aus einer von der ersten Kontaktfläche und von der zweiten Kontaktfläche bestimmten Ebene hinaussteht, der Verbinder insgesamt plan ausgebildet ist.

Außerdem ist die metallisierte Oberseite stoffschlüssig mit der einer der beiden Kontaktflächen d. h. mit der ersten Kontaktfläche oder mit der zweiten Kontaktfläche des ersten metallischen Verbinders verbunden. Hierbei liegt der durch die jeweilige Kontaktfläche des Verbinders überdeckte Flächenanteil zwischen 5 % und 90 % oder zwischen 10% und 30% der Gesamtfläche des jeweiligen Kontakts der Halbleiterdiode. Anders ausgedrückt, wenigstens 5% und maximal 90% oder wenigstens 10% und maximal 30% der Metallschicht an der Oberseite bzw. an der Unterseite der Halbleiterdiode weist eine stoffschlüssige Verbindung mit einem der beiden Verbinder auf.

Es versteht sich, dass zur Ausbildung der stoffschlüssigen Verbindung zwischen der jeweiligen Kontaktfläche der Halbleiterdiode mit der jeweiligen Kontaktfläche der Verbinder ein Lötprozess oder ein Schweißprozess durchgeführt wird.

Die metallisierte Unterseite ist stoffschlüssig mit einer der beiden Kontaktflächen, d.h. mit der ersten Kontaktfläche oder mit der Kontaktfläche des zweiten metallischen Verbinders verbunden.

Es sei angemerkt, dass die Kontaktflächen in bekannter Weise mit der Oberseite bzw. mit der Unterseite elektrisch verbunden sind. Insbesondere wird die stoffschlüssige Verbindung mittels einer Lötverbindung oder einer Schweißverbindung bewirkt.

Es versteht sich, dass die Halbleiterdiode eine p-dotierte Halbleiterschicht und einer n-dotierte Halbleiterschicht aufweist. Die beiden Halbleiterschichten sind ganzflächig ausgebildet und grenzen aneinander. Hierbei sei angemerkt, dass die Halbleiterdioden jeweils genau ein p/n Übergang aufweisen.

In einer Ausführungsform liegt die Dotierung der Halbleiterschichten an der Oberseite und an der Unterseite, um jeweils den Anschlusswiderstand d.h. den Kontaktwiderstand zu verringern, oberhalb von 1•10¹⁸/cm³.

Es versteht sich, dass die jeweiligen ungehäuste Halbleiterdioden keine Vergussmasse aufweisen. Vielmehr handelt es sich bei den Halbleiterdioden um sogenannte "bare die" Ausführungen.

Ein Vorteil der Diodenanordnung ist es, dass eine ultraflache und kompakte Anordnung bereitgestellt wird, die auch bei Strömen oberhalb von 1 Ampere die Wärme über die Verbinder zuverlässig abführt. Ein weiterer Vorteil ist, dass die ganzflächige Metallisierung die Halbleiterdiode zuverlässig vor Umwelteinflüssen wie Licht schützt und die Wärmeabfuhr verbessert.

Ein anderer Vorteil ist, dass sich ein kostengünstiges und zuverlässiges diskretes Bauelement herstellen lässt. Ein thermisch isolierendes Gehäuse entfällt.

Ein weiterer Vorteil ist, dass sich die Diodenanordnung leicht und gut handhabbar für eine weitere Verarbeitung ausgebildet ist.

In einer Weiterbildung ist auf der Oberseite genau ein erster Kontakt ausgebildet. Anders ausgedrückt, die gesamte Oberseite besteht aus dem ersten Kontakt.

In einer anderen Weiterbildung ist an der Unterseite des Dies unabhängig von der Größe genau ein einziger zweiter Kontakt ausgebildet.

In einer Ausführungsform sind auf der Oberseite mehrere nebeneinanderliegende erste Kontakte ausgebildet, wobei jeweils zwei unmittelbar benachbarte erste Kontakte mittels eines Mesagrabens voneinander elektrisch isoliert sind. Es versteht sich hierbei, dass die Tiefe des Mesagrabens derart ausgebildet ist, dass zumindest der p/n Übergang durchtrennt ist.

Des Weiteren ist auf der Unterseite ein einziger zweiter Kontakt ausbildet. Indem mehrere erste Kontakte und nur ein einziger zweiter Kontakt ausgebildet ist, lassen sich mehrere einzelne Dioden auf einfache Art und Weise auch parallel verschalten. Mit einer Parallelschaltung von mehreren einzelnen Dioden lässt sich der Widerstand und die Erwärmung der Diode reduzieren und die Ausfallsicherheit der Diodenanordnung, insbesondere bei einer Verwendung der Diodenanordnung als Schutzstruktur, erhöhen.

In einer Ausführungsform sind genau zwei erste Kontakte mit einem einzigen Verbinder elektrisch angeschlossen.

In einer Weiterbildung sind die mehreren ersten Kontakte in genau einer Reihe oder genau in zwei Reihen angeordnet. Vorzugsweise sind entlang einer Reihe genau drei erste Kontakte oder sechs erste Kontakte entlang von zwei parallel zueinander ausgebildeten Reihen entsprechend einer 2 x 3 Matrix angeordnet.

Ein Vorteil ist, dass bei mehreren ersten Kontakten auf einem Die bei einem Defekt in einem Gebiet eines der ersten Kontakte sich ein anderes Gebiet mit einem anderen ersten Kontakt elektrisch anschließen lässt. Anders ausgedrückt, das Die lässt sich weiter verwenden und die Ausbeute wird erhöht.

Des Weiteren lässt sich mit größeren Metallflächen die Wärmeabfuhr auch ohne zusätzlichen Kühlkörper erhöhen, wobei je größer dsa Die ist, d.h. je mehr erste Kontakte ausgebildet sind, Hierbei sind auf der Vorderseite sechs einzelne erste Kontakte ausgebildet.

In einer Ausführungsform ist auf der Oberseite oder auf der Unterseite ein Deckglas angeordnet, wobei zwischen dem Deckglas und der Kontaktfläche eine Schicht aus Klebstoff angeordnet ist. Es versteht sich, dass die Oberseite oder die Unterseite wenigstens teilweise stoffschlüssig mit Klebstoff bedeckt ist. Vorzugsweise ist auch wenigstens ein Teil der ersten Kontaktfläche oder der zweiten Kontaktfläche von dem Klebstoff bedeckt.

In einer Weiterbildung liegt die Dicke des Deckglases in einem Bereich zwischen 50 µm und 500 µm, vorzugsweise zwischen 60 µm und 300 µm.

In einer anderen Weiterbildung ist das Deckglas genau so groß wie die Oberfläche des Dies bzw. die Oberseite.

In einer Ausführungsform ist der Klebstoff zwischen dem Deckglas und Verbinder bzw. Oberseite oder Unterseite ausgebildet. Vorzugsweise ist kein Kleber oberhalb des Mittelstücks des Verbinders ausgebildet.

In einer Weiterbildung sind der Kleber und das Deckglas in dem sichtbaren Spektralbereich und in dem ultravioletten Spektralbereich transparent ausgebildet. Hierdurch lässt sich ein Großteil des durch das Deckglas eingestrahlten Sonnenlichtes reflektieren.

In einer Weiterbildung ist an der Unterseite und an der Oberseite jeweils nur ein umlaufender schmaler Bereich an der jeweiligen Kante nicht metallisiert.

In einer anderen Weiterbildung versteht es sich, dass die nicht metallisierten Bereiche entlang der Kante der Oberseite und oder die nicht metallisierten Bereiche entlang der Kante an der Unterseite eine Passivierung aufweisen.

In einer Ausführungsform umfasst die vorzugsweise schichtförmig ausgebildete Passivierung eine Oxid und eine Nitridschicht.

in einer Weiterbildung erstrecken sich die Metallschichten an der Unterseite und oder an der Oberseite jeweils von den unmittelbar an der Oberseite und oder an der Unterseite hochdotierten Halbleiterkontaktgebeten durchgängig bis auf die Passivierung. Anders ausgedrückt, der jeweils bis auf die Passivierung, d.h. der äußere Rand der Metallschichten ist hiernach ausschließlich auf der Passivierungsschicht ausgebildet.

In einer Weiterbildung weist die Oberseite und oder die Unterseite der Halbleiterdiode eine Fläche zwischen 0,01 cm² und 4 cm² oder eine Fläche zwischen 0,05 cm² und 0,5 cm² auf. Es versteht sich, dass die Strombelastbarkeit der Diodenanordnung mit einer größeren Fläche erhöht ist.

In einer Ausführungsform ist die Strombelastbarkeit der gesamten Diodenanordnung für max. 2 A oder für max. 5 A oder für max. 10 A oder für 20 A ausgelegt.

Vorzugsweise sind die Halbleiterdioden viereckig d.h. quadratisch oder echteckig ausgebildet.

In einer anderen Weiterbildung sind die beiden zweiten Kontaktflächen der Verbinder entgegengesetzt zueinander in einer ersten Näherung entlang einer Linie oder exakt entlang einer Linie angeordnet oder die beiden zweiten Kontaktflächen sind in einer ersten Näherung rechtwinklig oder exakt rechtwinklig zueinander angeordnet. Ein Vorteil bei beiden Anordnungen ist es, dass sich ein Kurzschluss zwischen Anode und Kathode wirkungsvoll vermeiden lässt.

In einer Weiterbildung sind die beiden Kontaktflächen der Verbinder jeweils plan ausgebildet.

In einer Ausführungsform bestehen die Verbinder aus einem Metall oder einer metallischen Verbindung. Vorzugsweise weisen die Verbinder jeweils ein einheitliches Material auf, d.h. die beiden Kontaktflächen und das Verbindungsstück sind aus dem gleichen Material ausgebildet.

In einer Weiterbildung liegt die Dicke des Materials der jeweiligen Verbinder in einem Bereich zwischen 0,01 mm und 1,2 mm. Vorzugsweise liegt die materialdicke des jeweiligen Verbinders in einem Bereich zwischen 0,04 mm und 0,3 mm.

In einer anderen Ausführungsform ist der erste Verbinder identisch oder in erster Näherung identisch wie der zweite Verbinder ausgeformt ist oder der erste Verbinder weist eine andere Form als der zweite Verbinder auf. Vorzugsweise handelt es sich bei den Verbindern um Gleichteile, um die Handhabung zu vereinfachen und die Kosten bei der Herstellung und Weiterverarbeitung zu reduzieren.

In einer anderen Ausführungsform ist der zweite Verbinder mit einer Oberseite oder einer Unterseite einer weiteren Halbleiterdiode verschaltet. Ferner ist bei der weiteren Halbleiterdiode die Unterseite oder die Oberseite mit einer ersten Kontaktfläche oder mit einer der beiden Kontaktflächen eines dritten Verbinders verbunden, so dass die beiden Halbleiterdioden in Serie verschaltet sind.

Es versteht sich, dass sich mittels einer Parallelschaltung sich die Stromtragfähigkeit und mit einer Serienschaltung die Spannungsfestigkeit erhöht.

In einer Weiterbildung umfasst das Verbindungsstück zwischen der ersten Kontaktfläche und der zweiten Kontaktfläche mäanderförmige Metallstreifen oder das Verbindungsstück besteht aus mäanderförmigen Metallstreifen, wobei die Metallstreifen bevorzugt parallel zueinander angeordnet sind. Mittels der mäanderförmigen Anordnung lässt sich eine mechanische Entkopplung und / oder thermische Entkopplung zwischen der ersten Kontaktfläche und der zweiten Kontaktfläche erhöhen.

In einer anderen Weiterbildung ist die erste Kontaktfläche und / oder die zweite Kontaktfläche wenigstens teilweise gabelförmig ausgebildet und genau ein Fahnenstück oder genau zwei Fahnenstücke oder wenigstens oder genau drei Fahnenstücke aufweist und die mehreren Fahnenstücke zueinander beabstandet und parallel ausgebildet sind.

Mittels der gabelförmigen Ausführung lässt sich der Scherrstress bei Temperaturschwankungen bedingt durch unterschiedliche Ausdehnungskoeffizienten zwischen der Halbleiterdiode und den Kontaktflächen reduzieren.

In einer Ausführungsform kontaktiert die erste Kontaktfläche des ersten Verbinders zwei nebeneinander angeordnete Halbleiterdioden gleichzeitig.

In einer anderen Ausführungsform weist die Anordnung aus Verbinder und Halbleiterdiode eine Dicke zwischen 0,03 mm und 1,5 mm oder zwischen 0,1 mm und 0,5 mm auf.

In einer Weiterbildung sind die Halbleiterdiode vollständig und wenigstens Teile von einem oder von beiden Verbinder abgedeckt. Vorzugsweise umfasst die Abdeckung organische und anorganische Materialien. Mittels der Abdeckung lassen sich die Oberseite und oder die Unterseite vor Umwelteinschlüssen schützen.

In einer Ausführungsform ist die Abdeckung plattenförmig ausgebbildet und mittels eines Klebers bzw. mittels einer Klebeschicht mit der Oberseite und oder der Unterseite verbunden. Die Abdeckung und die Klebeschicht bestehen aus unterschiedlichen Materialien. Die Klebeschicht umfasst oder besteht aus organischen Materialien. Vorzugsweise weist die Klebeschicht und die Abdeckschicht eine Gesamtdicke zwischen 40 µm und 500 µm oder zwischen 80 µm und 200 µm auf.

In einer anderen Weiterbildung sind die Verbinder und die Halbleiterdiode in einer Ebene oder nahezu in einer Ebene angeordnet.

In einer Ausführungsform weisen die Verbinder jeweils plane Kontaktflächen auf.

In einer Ausführungsform weist der Verbinder zwischen der ersten Kontaktfläche und der zweiten Kontaktfläche einen kleinen Versatz auf, so dass die beiden Kontaktflächen in unterschiedlichen Ebenen ausgebildet sind.

In einer Ausführungsform ist der Versatz bei den Verbindern zwischen einer der beiden Kontaktflächen und dem Verbindungsstück ausgebildet.

In einer anderen Ausführungsform entspricht der Versatz in einer ersten Näherung der Dicke der Halbleiterdiode. Anders ausgedrückt, der Versatz d.h. der Abstand zwischen den beiden Ebenen der beiden Kontaktflächen des jeweiligen Verbinders in Richtung der Normalen der beiden Ebenen ist größer als 0,1 mm und kleiner als 1,5 mm.

In einer Weiterbildung ist die Halbleiterdiode als Siliziumdiode ausgebildet.

In einer Ausführungsform weist die Halbleiterdiode eine Dicke zwischen 50 µm und 600 µm auf.

In einer Ausführungsform liegt die Sperrspannung der Halbleiterdiode in einem Bereich zwischen 20 V und 800 V. Vorzugsweise liegt die Sperrspannung in einem Bereich zwischen 100 V und 300 V.

in einer Weiterbildung beträgt der Anteil der Fläche des ersten Kontakts und / oder des zweiten Kontakts bei dem eine stoffschlüssige Verbindung mit einem der beiden Kontaktflächen ausgebildet ist, zwischen 5% und 90 % der jeweiligen Gesamtfläche der beiden Kontakte, d.h. die Metallschicht an der Oberseite und an der Unterseite der Halbleiterdiode ist großflächig mit den Verbindern verbunden. Hierdurch lässt sich eine niederohmige elektrische Verschaltung erzielen.

In einer Ausführungsform sind die beiden Verbinder sind als plane oder nahezu plane Gleichteile ausgebildet.

In einer Weiterbildung sind die jeweiligen Verbinder entlang einer Linie senkrecht zu der langen Seite des Verbinders spiegelsymmetrisch ausgebildet. In einer anderen Ausführungsform weisen die Verbinder oder wenigstens einer der Verbinder keine Spiegelsymmetrie auf.

In einer Ausführungsform sind die Verbinder unterschiedlich zueinander ausgebildet.

In einer Ausführungsform weist wenigstens einer der Verbinder oder alle Verbinder entlang der langen Seite eine Stufe auf.

In einer Weiterbildung ist die Höhe der Stufe um mindestens einen Faktor 20 kleiner als die Erstreckung des Verbinders entlang der langen Seite.

In einer Weiterbiidung sind die Verbinder sind als flache oder nahezu als flache Metallfahnen ausgebildet und weisen eine Dicke zwischen 50 µm und 500 µm oder zwischen 80 µm und 200 µm auf.

In einer Ausführungsform liegt das Verhältnis von einer Länge der Verbinder zu deren Breiten in einem Bereich zwischen 3 bis 10. Vorzugsweise weisen die Verbinder eine Breite zwischen 0,5 cm und 3 cm auf.

Die Erfindung wird nachfolgend unter Bezugnahme auf die Zeichnungen näher erläutert. Hierbei werden gleichartige Teile mit identischen Bezeichnungen beschriftet. Die dargestellten Ausführungsformen sind stark schematisiert, d.h. die Abstände und die lateralen und die vertikalen Erstreckungen sind nicht maßstäblich und weisen, sofern nicht anders angegeben, auch keine ableitbaren geometrischen Relationen zueinander auf. Darin zeigen, die
- Figur 1a: eine Vorderansicht auf eine Vorderansicht einer Diodenanordnung mit einer Halbleiterdiode und mit zwei Verbindern und mit zwei Schnittlinien A-A' und B-B',
- Figur 1b: eine Seitenansicht entlang der Schnittlinie A-A' der Ausführungsform, dargestellt in Zusammenhang mit der Fig. 1a,
- Figur 1c: eine Seitenansicht entlang der Schnittlinie B-B' der Ausführungsform, dargestellt in Zusammenhang mit der Fig. 1a, wobei auf der Vorderseite eine Klebeschicht mit einer Abdeckung angeordnet ist,
- Figur 2a: eine Draufsicht auf eine Ausführungsform eines Verbinders,
- Figur 2b: eine Seitenansicht auf die Ausführungsform der Fig. 2a ,
- Figur 3a: eine Draufsicht auf eine weitere Ausführungsform eines Verbinders,
- Figur 3b: eine Seitenansicht auf die Ausführungsform der Fig. 3a,
- Figur 4: eine Draufsicht auf eine andere Ausführungsform eines Verbinders,
- Figur 5a1: eine Vorderansicht auf eine Diodenanordnung mit einer Halbleiterdiode und mit einer Abdeckung und mit zwei Verbindern,

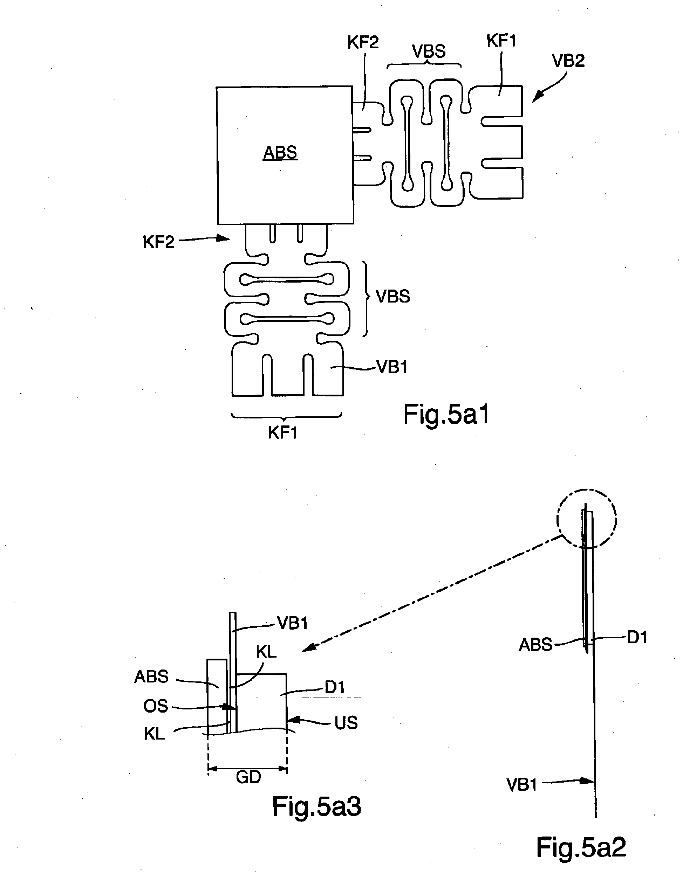

- Figur 5a2: eine Seitenansicht auf die Ausführungsform, dargestellt in der Figur 5a1,
- Figur 5a3: ein vergrößerter Ausschnitt auf einen Teil der Seitensicht, dargestellt in der Fig. 5a2,

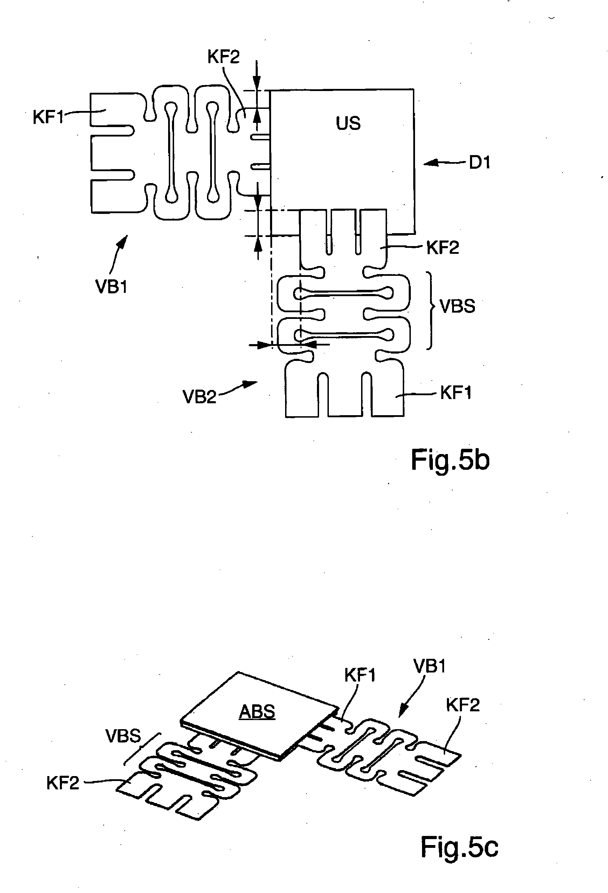

- Figur 5b: eine Rückansicht auf die Ausführungsform, dargestellt in der Fig. 5a,
- Figur 5c: eine perspektivische Ansicht auf die Ausführungsform, dargestellt in der Fig. 5a,

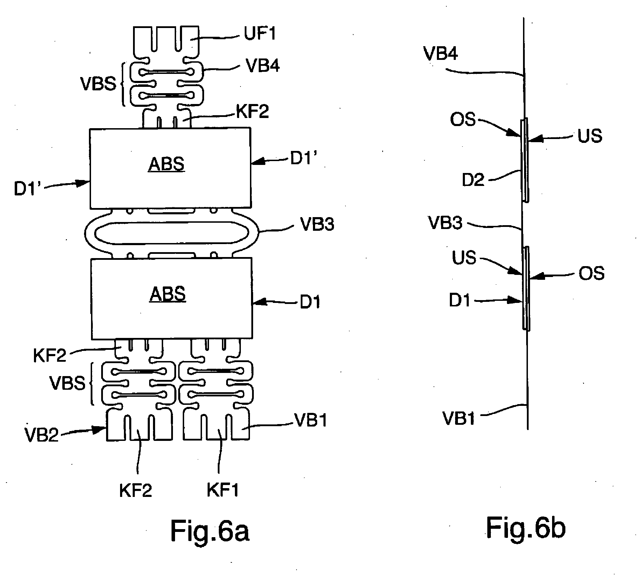

- Figur 6a: eine Vorderansicht auf eine Diodenanordnung umfassend eine Serienschaltung von zwei Dioden mit jeweils einer Abdeckung und mehreren Verbindern,
- Figur 6b: eine Seitenansicht auf die Ausführungsform, dargestellt in der Fig. 6a,

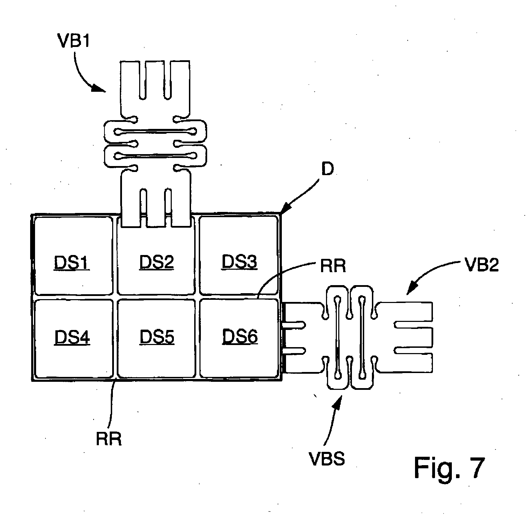

- Figur 7: eine Vorderansicht auf eine Diodenanordnung umfassend mehrere durch Mesagräben voneinander auf der Vorderseite isolierte Dioden.

In den nachfolgenden Ausführungsformen der Diodenanordnung sind die jeweiligen Dioden als Halbleiterdioden ohne Gehäuse ausgebildet und weisen insbesondere keine Vergussmasse auf. Vielmehr handelt es sich um sogenannte "bare Die" Ausführungen. Die Halbleiterdioden sind viereckig im Allgemeinen entweder quadratisch oder rechteckig ausgebildet.

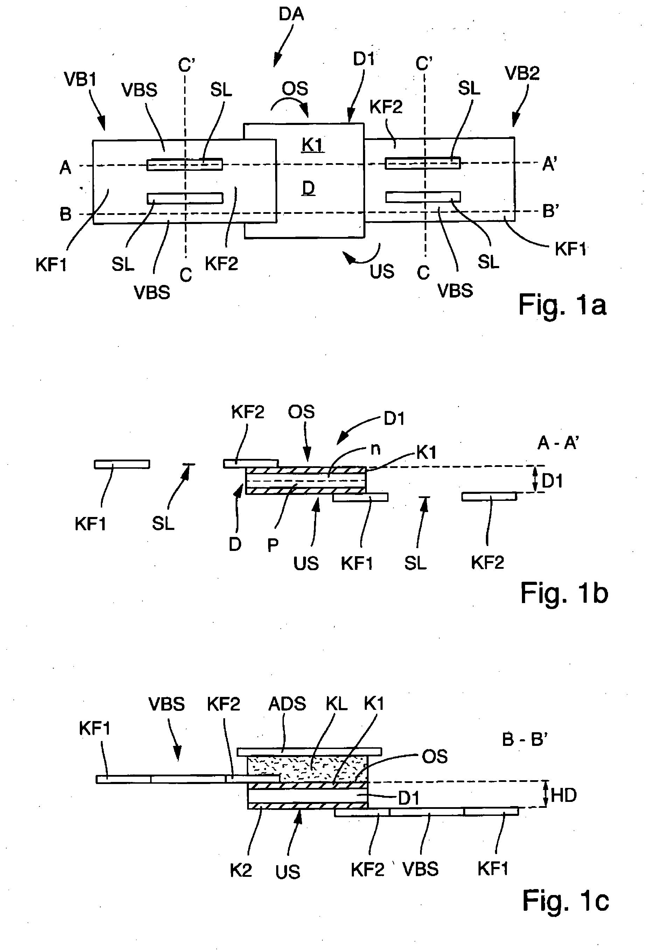

Die Abbildung der Figur 1a zeigt eine Vorderansicht einer Diodenanordnung DA mit einer Halbleiterdiode D1 und mit zwei Verbindern VB1 und zwei Schnittlinien A-A' und B-B'.

Die Halbleiterdiode D1 weist ausgehend von einer Oberseite OS in Richtung zu einer Unterseite US einen ersten Halbleiterbereich mit einer Dotierung von einem ersten Typ und ausgehend von der Unterseite US in Richtung zu Oberseite OS einen zweiten Halbleiterbereich mit einer Dotierung von einem zweiten Typ auf. Hierdurch bildet sich genau ein p / n Übergang aus.

Es versteht sich, dass der erste Typ als p-Dotierung und der zweite Typ als n-Dotierung ausgebildet oder der erste Typ als n-Dotierung und der der zweite Typ als p-Dotierung ausgebildet ist.

An der Oberseite OS ist eine erster elektrischer Kontakt K1 und an der Unterseite ein zweiter elektrischer Kontakt K2 ausgebildet.

Die Halbleiterdiode D1 ist als diskretes Bauelement ungehäust als flächiges Die D ausgebildet. Die Oberseite OS und die Unterseite US sind jeweils plan und zueinander parallel ausgebildet.

Der erste Kontakt K1 und der zweite Kontakt K2 ist jeweils als Metallschicht ausgeführt, wobei die Metallschicht vorliegend mehr als 80% der gesamten Fläche der Oberseite OS und mehr als 80 % der gesamten Fläche der Unterseite US überdeckt.

Anders ausgedrückt, nahezu die gesamte Fläche der Unterseite US ist metallisiert und nahezu die gesamte Fläche der Oberseite OS ist metallisiert.

Ferner umfasst die Diodenanordnung DA einen ersten metallischen Verbinder VB1. Der erste Verbinder VB1 ist flach d.h. plan oder zumindest in einer ersten Näherung plan ausgeführt und weist eine erste Kontaktfläche KF1 und eine von der ersten Kontaktfläche KF1 durch ein Verbindungsstück VBS beabstandete zweiten Kontaktfläche KF2 auf.

Des Weiteren umfasst die Diodenanordnung einen zweiten metallischen Verbinder VB2, wobei der zweite Verbinder VB2 flach d.h. plan oder zumindest in einer ersten Näherung plan ausgeführt ist und eine erste Kontaktfläche KF1 und eine von der ersten Kontaktfläche KF1 durch ein Verbindungsstück VBS beabstandete zweiten Kontaktfläche KF2 aufweist.

Bei dem ersten Verbinder VB1 und bei dem zweiten Verbinder VB2 weisen in dem Bereich des Verbindungsstücks VBS jeweils zwei schlitzförmige Aussparungen SL auf.

Der erste Kontakt K1, d.h. die Metallschicht auf der Oberseite OS der Halbleiterdiode D, ist stoffschlüssig mit der zweiten Kontaktflächen KF2 des ersten metallischen Verbinders VB1 verbunden.

Des Weiteren ist der zweite Kontakt K2, d.h. die Metallschicht auf der Unterseite US der Halbleiterdiode D1 mit der ersten Kontaktfläche KF1 des zweiten metallischen Verbinders VB2 verbunden.

Vorliegend liegt der Anteil der Fläche des ersten Kontakts K1 und / oder des zweiten Kontakts K2 bei der eine stoffschlüssige Verbindung mit einem der beiden Kontaktflächen KF1 und KF2 ausgebildet ist in einem Bereich zwischen 5 % und 90 % der jeweiligen Gesamtfläche der beiden Kontakten K1, K2.

Die beiden Verbinder VB1, VB2 sind als plane Gleichteile und entlang einer Linie C-C', die senkrecht zu der langen Seite des jeweiligen Verbindersverläuft, spiegelsymmetrisch ausgebildet.

In einer nicht dargestellten Ausführungsform sind die beiden Verbinder VB1, VB2 unterschiedlich zueinander ausgebildet. In einer anderen nicht dargestellten Ausführungsform weist der jeweilige Verbinder VB1, VB2 keine entlang der Linie C-C' ausgebildete Spiegelsymmetrie auf.

Die Verbinder VB1, VB2 sind jeweils als flache Metallfahnen ausgebildet und weisen eine Dicke in einem Bereich zwischen 50 µm und 500 µm auf. In einer nicht dargestellten Ausführungsform weist wenigstens einer der Verbinder oder alle Verbinder VB1, VB2 entlang der langen Seite eine Stufe auf. Hierbei ist die Höhe der Stufe um mindestens einen Faktor 20 kleiner als die Erstreckung des Verbinders VB1, VB2 entlang der langen Seite.

Die Abbildung der Figur 1b zeigt eine Seitenansicht entlang der Schnittlinie A-A' der Ausführungsform, dargestellt in Zusammenhang mit der Fig. 1a. Im Folgenden werden nur die Unterschiede zu der Ausführungsform der Fig. 1a erläutert.

Bei dem ersten Verbinder VB1 und bei dem zweiten Verbinder VB2 ist jeweils die erste Kontaktfläche KF1 von der zweiten Kontaktfläche KF2 wegen der schlitzförmigen Aussparung SL voneinander getrennt.

Die zweiten Kontaktfläche KF2 des ersten Verbinders VB1 ist stoffschlüssig mit dem ersten Kontakt K1 an der Oberseite OS der Halbleiterdiode D1 verbunden. Ferner ist die erste Kontaktfläche KF1 des zweiten Verbinders VB2 ist stoffschlüssig mit dem zweiten Kontakt K2 an der Unterseite US der Halbleiterdiode D1 verbunden. Vorzugsweise werden die stoffschlüssigen Verbindungen mittels eines Lotprozesses oder eines Schweißprozesses hergestellt.

Die Halbleiterdiode D1 ist plan ausgebildet und weist eine Dicke HD in einem Bereich zwischen 50 µm und 500 µm auf.

Die Metallschicht des ersten Kontakts K1 bedeckt die gesamte Oberseite OS, während die Metallschicht des zweiten Kontakts die gesamte Unterseite bedeckt. Aus Gründen der Übersichtlichkeit nicht dargestellt ist, dass die Metallschicht an der Oberseite OS und an der Unterseite US nicht bis unmittelbar an die jeweilige Kante der Halbleiterdiode D1 an der Oberseite OS und an der Unterseite US ausgebildet ist.

Die Halbleiterdiode D1 weist vorliegend eine n-dotierter Bereich an der Oberseite OS und einen p-dotierten Bereich an der Unterseite US auf. Mit der gestrichelten Linie zwischen den beiden Bereichen wird vorliegend der p/n Übergang skizziert.

Die Abbildung der Figur 1c zeigt eine Seitenansicht entlang der Schnittlinie B-B' der Ausführungsform, dargestellt in Zusammenhang mit der Fig. 1a, wobei auf der Vorderseite eine Klebeschicht KL mit einer Abdeckung ADS angeordnet ist. Im Folgenden werden nur die Unterschiede zu der vorangegangenen Ausführungsform, dargestellt in der Fig. 1a bzw. in der Fig. 1b erläutert.

Auf der Oberseite OS der Halbleiterdiode D1 ist der Teil der zweiten Kontaktfläche KF2 der mit dem ersten Kontakt K1 verbunden ist sowie die restliche Fläche der Oberseite OS von der Klebeschicht KL überdeckt. Oberhalb der Klebeschicht KL ist die Abdeckung ADS angeordnet, wobei die Klebeschicht KL die Abdeckung ADS mit der Halbleiterdiode D1 verbindet. Die Abdeckung ADS und die Klebeschicht KL bestehen aus unterschiedlichen Materialien. Die Klebeschicht KL umfasst oder besteht aus organischen Materialien.

Die Abdeckung ADS ist als dünnes Plättchen mit einer Dicke zwischen 30 µm und 150 µm ausgebildet und schützt die Oberseite OS von Umwelteinflüssen.

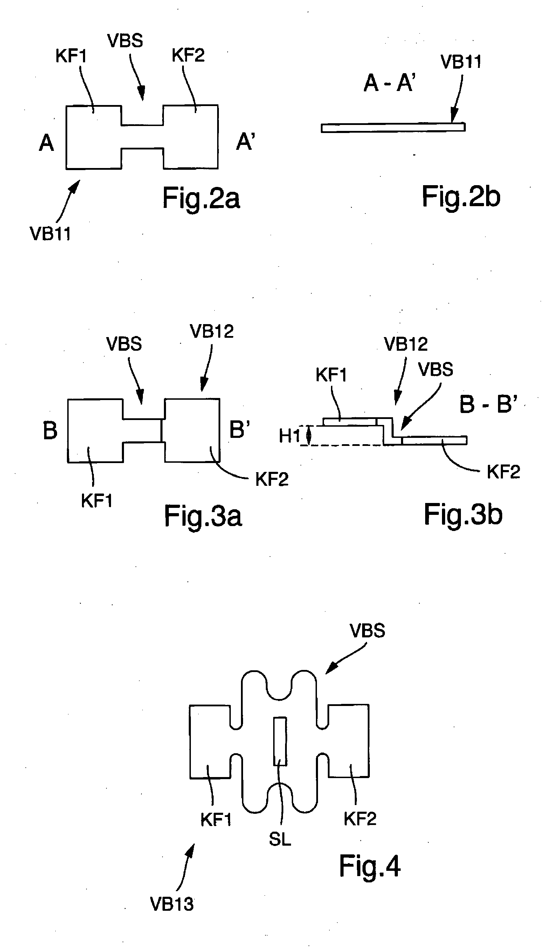

Die Abbildung der Figur 2a zeigt eine Draufsicht auf eine zweite Ausführungsform des Verbinders VB1, VB2, wobei die Abbildung der Figur 2b eine Seitenansicht auf die Ausführungsform der Fig. 2a darstellt. Im Folgenden werden nur die Unterschiede der zweiten Ausführungsform des Verbinders VB1, VB2 zu vorangegangenen Ausführungsformen erläutert.

Das Verbindungsstück VBS weist eine geringere Breite als die beiden Kontaktflächen KF1, KF2 auf. Auch sind in dem Bereich des Verbindungstücks VBS keine Schlitze SL ausgebildet.

Die Abbildung der Figur 3a zeigt eine Draufsicht auf eine dritte Ausführungsform des Verbinders VB1, VB2, wobei die Abbildung der Figur 3b eine Seitenansicht auf die Ausführungsform der Fig. 3a darstellt. Im Folgenden werden nur die Unterschiede der dritten Ausführungsform des Verbinders VB1, VB2 zu vorangegangenen Ausführungsformen erläutert.

Im Bereich des Verbindungsstücks VBS ist nunmehr zwischen der ersten Kontaktfläche KF1 und der zweiten Kontaktfläche KF2 eine Stufe mit einer Höhe H1 ausgebildet.

Die Höhe H1 der Stufe liegt vorzugsweise in einem Bereich zwischen 200 µm und 800 µm. Abgesehen von der Stufe sind wie in den vorangegangenen Ausführungsformen die Kontaktflächen KF1, KF2 plan ausgebildet.

Die Abbildung der Figur 4 zeigt eine Draufsicht auf eine vierte Ausführungsform des Verbinders VB1, VB2. Im Folgenden werden nur die Unterschiede der vierten Ausführungsform des Verbinders VB1, VB2 zu vorangegangenen Ausführungsformen erläutert.

Das Verbindungsstück VBS weist einen mäanderförmigen Verlauf mit einer variierenden Breite auf. Senkrecht zu der langen Seite des Verbinders VB1, VB2 ist in dem Bereich des Verbindungsstück VBS ein Schlitz SL ausgebildet, wobei der Verbinder VB1, VB2 insgesamt plan, d.h. ohne Stufe ausgebildet ist.

Die Abbildung der Figur 5a1 zeigt eine Draufsicht auf eine Diodenanordnung DA mit einer Halbleiterdiode D1 unter der Abdeckung ABS und zwei Verbindern VB1, VB2. Die Abbildung der Figur 5a2 zeigt eine Seitenansicht auf die Ausführungsform, dargestellt in der Figur 5a1 und die Abbildung der Figur 5a3 zeigt einen vergrößerten Ausschnitt auf einen Teil der Seitensicht, dargestellt in der Fig. 5a2.

Im Folgenden werden nur die Unterschiede der Ausführungsform zu der Diodenanordnung DA der Fig. 1a und 1b erläutert. Aus Gründen der Übersichtlichkeit sind die Metallschichten und der erste Kontakt K1 an der Oberseite und der zweite Kontakt K2 an der Unterseite US nicht eingezeichnet.

Auf der Oberseite OS der Halbleiterdiode D1 ist die Abdeckung ABS angeordnet, wobei die Abdeckung ABS die Halbleiterdiode D1 an allen Seiten etwas überragt. Der erste Verbinder VB1 und der zweite Verbinder VB2 sind als Gleichteile ausgeführt, wobei im Unterschied zu den vorangegangenen Ausführungsformen die erste Kontaktfläche KF1 und die zweite Kontaktfläche KF2 jeweils anstelle einer durchgehenden Kontaktfläche drei zinkenförmige Ausbildungen aufweisen.

Ferner ist die Breite der ersten Kontaktfläche KF1 jeweils größer als die Breite der zweiten Kontaktfläche KF2. Bei beiden Verbindern VB1, VB2 ist jeweils die zweite Kontaktfläche KF2 mit einer der beiden Kontakte K1, K2 der Halbleiterdiode D1 verbunden.

Bei den Verbindern VB1, VB2 ist jeweils das Verbindungsstück VBS mäanderförmig ausgebildet um die beiden Kontaktflächen KF1, KF2 thermisch und mechanisch voneinander zu entkoppeln.

Die langen Seiten der Verbinder VB1, VB2 weisen zueinander einen Winkel von 90° auf, d.h. die Verbinder VB1, VB2 sind zueinander rechtwinklig angeordnet.

Die Gesamtdicke GD der Anordnung aus Abdeckung ABS, Klebeschicht KL, zweite Kontaktfläche KF2 und Halbleiterdiode D2 ist kleiner als 1,6mm.

Die Abbildung der Figur 5b zeigt eine Rückansicht auf die Ausführungsform, dargestellt in der Fig. 5a, wobei die Abbildung der Figur 5c eine perspektivische Ansicht auf die Ausführungsform, dargestellt in der Fig. 5a, veranschaulicht. Im Folgenden werden nur die Unterschiede der Ausführungsform zu der Diodenanordnung DA der Fig. 5a1 bis 5a3 erläutert.

Alle drei zinkenförmigen Ausbildungen der zweiten Kontaktfläche KF2 des zweiten Verbinders VB2 sind mit dem zweiten Kontakt K2 an der Unterseite US der Halbleiterdiode D1 verbunden.

Die Unterseite US der Halbleiterdiode D1 ist im Unterschied zu der Oberseite OS der Halbleiterdiode D1 nicht abgedeckt, d.h. weist keine Abdeckung ABS auf.

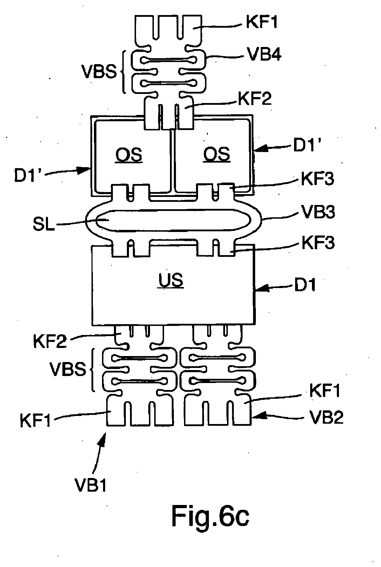

Die Abbildung der Figur 6a zeigt eine Vorderansicht auf eine Diodenanordnung DA umfassend eine Serienschaltung in Verbindung mit einer Parallelschaltung von insgesamt drei Halbleiterdioden D1, D1' mit jeweils einer Abdeckung ABS und mehreren Verbindern VB1, VB2, VB3 wobei die Abbildung der Fig. 6b eine Seitenansicht und die Abbildung der Fig. 6c eine Rückseitenansicht der Ausführungsform, dargestellt in der Fig. 6a, veranschaulicht.

Im Folgenden werden nur die Unterschiede zu den vorangegangenen Diodenanordnungen DA in der Abbildung 5a1 bis 5c erläutert.

Die Halbleiterdiode D1 ist nunmehr nicht quadratisch sondern rechteckig ausgebildet und weist an der Oberseite OS ebenfalls die Abdeckung ABS auf. Die Oberseite OS, d.h. der erste Kontakt K1, ist mittels der zweiten Kontaktflächen KF2 des ersten Verbinders VB1 und des zweiten Verbinders VB2 parallel angeschlossen. Hierdurch steigt die Strombelastbarkeit bzw. die Zuverlässigkeit des elektrischen Anschlusses.

Die Unterseite US der Halbleiterdiode D1 ist von einer dritten Kontaktfläche KF3 eines dritten Verbinders VB3 angeschlossen. Der dritte Verbinder VB3 weist eine andere Form als die beiden Verbinder VB1, VB2 auf.

Mittels der weiteren dritten Kontaktfläche KF3 ist die Oberseite von zwei weiteren zueinander parallelgeschalteten Halbleiterdioden D1' verschaltet. Hierzu sind die beiden quadratisch ausgebildeten Halbleiterdioden D1` mit der Oberseite OS nach unten d.h. gedreht angeordnet.

Anders ausgedrückt die Oberseite OS der beiden kleinen quadratisch ausgebildeten Halbleiterdioden D1' sind mit der Unterseite der rechteckig ausgebildeten Halbleiterdiode D1 seriell verschaltet.

Indem die beiden kleinen quadratisch ausgebildeten Halbleiterdioden D1' mit der jeweiligen Unterseite US nach oben zeigen, weisen die beiden Unterseiten US der kleinen quadratisch ausgebildeten Halbleiterdioden D1' Abdeckung ABS auf.

Im weiteren Verlauf sind die beiden Unterseite US der beiden kleinen quadratischen Halbeliterdioden D1 mit der zweiten Kontaktfläche KF2 eines vierten Verbinders VB4 verschaltet. Hierbei weist der vierte Verbinder VB4 eine gleiche geometrische Form wie die beiden Verbinder VB1, VB2 auf.

In der Abbildung der Figur 7 ist eine Draufsicht auf die Oberseite des Dies D abgebildet. Im Unterschied zu den vorangegangenen Ausführungsformen umfasst das Die D nunmehr mehrere mittels des Ritzrahmens RR elektrisch getrennte Dioden DS1 - DS6.

Die insgesamt sechs Dioden DS1 - DS6 sind in zwei Reihen angeordnet, wobei das Die D eine rechteckige Form aufweist.

Die Unterseite US ist nicht dargestellt. Die Unterseite US ist jedoch ganzflächig metallisiert und mittels des Verbinder VB2 kontaktiert. An der Oberseite ist mittels eines der Verbinder VB1 eine Diode DS2 kontaktiert.

## Patentansprüche

1. Diodenanordnung (DA) als ungehäustes Fertigprodukt aufweisend, eine Halbleiterdiode (D1) mit genau einem p / n Übergang, wobei die Halbleiterdiode (D1) eine p-dotierte Oberseite (OS) und eine n-dotierte Unterseite (US) oder eine n-dotierte Oberseite (OS) und eine p-dotierte Unterseite aufweist, und an der Oberseite ein erster elektrischer Kontakt (K1) und an der Unterseite (US) ein zweiter elektrischer Kontakt (K2) ausgebildet ist,
**dadurch gekennzeichnet, dass**
- die ungehäuste Halbleiterdiode (D1) als diskretes Bauelement und als flächiges Die ausgebildet ist,
- die Halbleiterdiode (D1) eine plane Oberseite und eine plane Unterseite aufweist,
- die Fläche der Oberseite und die Fläche der Unterseite vollständig oder wenigstens zu mehr als 90% metallisiert sind, und die metallisierte Oberseite den ersten Kontakt (K1) und die metallisierte Unterseite den zweiten Kontakt (K2) der Halbleiterdiode (D1) ausbildet,
- ein erster flacher metallischer Verbinder (VB1) mit einer ersten Kontaktfläche (KF1) und einer von der ersten durch ein Verbindungsstück (VBS) beabstandeten zweiten Kontaktfläche (KF2) ausgebildet ist,
- ein zweiter flacher metallischer Verbinder (VB2) mit einer ersten Kontaktfläche (KF1) und einer von der ersten durch ein Verbindungsstück (VBS) beabstandeten zweiten Kontaktfläche (KF2) ausgebildet ist,
- das jeweilige Verbindungsstück bei den beiden Verbindern nicht oder nicht mehr als 1,5 mm aus einer von der ersten Kontaktfläche (KF1) oder von der zweiten Kontaktfläche (KF2) bestimmten Ebene hinaussteht,
- die metallisierte Oberseite (OS) stoffschlüssig mit der einer der beiden Kontaktflächen (KF1, KF2) des ersten metallischen Verbinders (VB1) verbunden ist,
- die metallisierte Unterseite (US) stoffschlüssig mit einer der beiden Kontaktflächen (KF1, KF2) des zweiten metallischen Verbinders (VB2) verbunden ist.

2. Diodenanordnung (DA) nach Anspruch 1, **dadurch gekennzeichnet, dass** die Oberseite (OS) genau einen ersten Kontakt (K1) aufweist.

3. Diodenanordnung (DA) nach Anspruch 1 oder Anspruch 2, **dadurch gekennzeichnet, dass** unabhängig von der Größe des Dies die Unterseite (US) eine genau einen einzigen zweiten Kontakt (K2) aufweist.

4. Diodenanordnung (DA) nach einem der vorangegangenen Ansprüche, **dadurch gekennzeichnet, dass** auf der Oberseite (OS) mehrere nebeneinanderliegende erste Kontakte (K1) ausgebildet sind, wobei jeweils zwei unmittelbar benachbarte erste Kontakte (K1) mittels eines Mesagrabens voneinander elektrisch isoliert sind.

5. Diodenanordnung (DA) einem der vorangegangenen Ansprüche, **dadurch gekennzeichnet, dass** genau zwei erste Kontakte (K1) mit einem einzigen Verbinder (VB1, VB2) elektrisch angeschlossen sind.

6. Diodenanordnung (DA) einem der vorangegangenen Ansprüche, **dadurch gekennzeichnet, dass** auf der Oberseite (OS) oder auf der Unterseite (US) ein Deckglas angeordnet ist, wobei zwischen dem Deckglas und der Kontaktfläche (KF1, KF2) eine Schicht aus Klebstoff angeordnet ist.

7. Diodenanordnung (DA) nach Anspruch 6, **dadurch gekennzeichnet, dass** der Kleber und das Deckglas in dem sichtbaren Spektralbereich und in dem ultravioletten Spektralbereich transparent sind.

8. Diodenanordnung (DA) nach einem der vorstehenden Ansprüche, **dadurch gekennzeichnet, dass** das Verbindungsstück (VBS) zwischen der ersten Kontaktfläche (KF!) und der zweiten Kontaktfläche (KF2) mäanderförmige Metallstreifen umfassen oder aus mäanderförmigen Metallstreifen bestehen.

9. Diodenanordnung (DA) nach einem der vorstehenden Ansprüche, **dadurch gekennzeichnet, dass** die erste Kontaktfläche und oder die zweite Kontaktfläche wenigstens teilweise gabelförmig ausgebildet ist und genau ein Fahnenstück oder genau zwei Fahnenstücke oder wenigstens oder genau drei Fahnenstücke aufweist und die mehreren Fahnenstücke zueinander beabstandet und parallel ausgebildet sind.

10. Diodenanordnung (DA) nach einem der vorstehenden Ansprüche, **dadurch gekennzeichnet, dass** die erste Kontaktfläche des ersten Verbinders zwei nebeneinander angeordneten Halbleiterdioden gleichzeitig kontaktiert

11. Diodenanordnung (DA) nach einem der vorstehenden Ansprüche, **dadurch gekennzeichnet, dass** die Anordnung aus Verbinder (VB1, VB2) und Halbleiterdiode (D1) eine Dicke zwischen 0,03 mm und 1,5 mm oder zwischen 0,1 mm und 0,5 mm aufweist.

12. Diodenanordnung (DA) nach einem der vorstehenden Ansprüche, **dadurch gekennzeichnet, dass** die Halbleiterdiode (D1) an der Oberseite (OS) oder an der Unterseite (US) und der auf der Oberseite (OS) oder der Unterseite (US) angeordnete Teil der Kontaktfläche (KF1, KF2) abgedeckt ist.

13. Diodenanordnung (DA) nach einem der vorangegangenen Ansprüche, **dadurch gekennzeichnet, dass** die Verbinder (VB1, VB2) und die Halbleiterdiode (D1) in einer Ebene oder nahezu in einer Ebene angeordnet sind.

14. Diodenanordnung (DA) nach einem der vorangegangenen Ansprüche, **dadurch gekennzeichnet, dass** bei den Verbindern (VB1, VB2) zwischen einer der beiden Kontaktflächen (KF1, KF2) und dem Verbindungsstück (VBS) ein Versatz ausgebildet ist und der Versatz in einer ersten Näherung der Dicke der Halbleiterdiode (D1) entspricht.

15. Diodenanordnung (DA) nach einem der vorangegangenen Ansprüche, **dadurch gekennzeichnet, dass** die Halbleiterdiode (D1) als Siliziumdiode ausgebildet ist.
